# EUROPEAN PATENT APPLICATION

(11) **EP 4 739 026 A1**
(43) Date of publication of application: **06.05.2026**
(21) Application number: 25213627.0
(22) Date of filing: 05.11.2025
(51) Int. Cl.: H10B 63/10, H10N 70/20

(54) **SINGLE ETCH AND PIER MERGE METHOD FOR CELL AND COMB FEATURES**

(30) Priority: 05.11.2024 US 202463716589 P; 29.10.2025 US 202519373370
(71) Applicant: MICRON TECHNOLOGY, INC., Boise, ID 83716-9632 (US)
(72) Inventor: GOOD, Farrell M., Boise, 83716-9632 (US); PLAISTED, Trevor J., Boise, 83716-9632 (US)
(74) Representative: Marks & Clerk LLP

(57) **Abstract**

Methods, systems, and devices for single etch and pier merge method for cell and comb features are described. One or more pillars and one or more piers for a memory array may be patterned, aligned, and formed in one processing step. For example, the one or more piers and the one or more pillars may be patterned and etched using a pillar shape to form a set of pillar cavities. A first subset of the pillar cavities may be etched such that pairs of adjacent pillar cavities merge to form a pier cavity that is filled with a first material and a liner to form the one or more piers. A second subset of the pillar cavities may be filled with the liner and the first material to form the one or more pillars. Comb edge structures may be formed based on a third subset of the pillar cavities.

## Description

### TECHNICAL FIELD

The following relates to one or more systems for memory, including single etch and pier merge method for cell and comb features.

### BACKGROUND

Memory devices are widely used to store information in devices such as computers, user devices, wireless communication devices, cameras, digital displays, and others. Information is stored by programming memory cells within a memory device to various states. For example, binary memory cells may be programmed to one of two supported states, often denoted by a logic 1 or a logic 0. In some examples, a single memory cell may support more than two states, any one of which may be stored. To access the stored information, the memory device may read (e.g., sense, detect, retrieve, determine) states from the memory cells. To store information, the memory device may write (e.g., program, set, assign) states to the memory cells.

Various types of memory devices exist, including magnetic hard disks, random access memory (RAM), read-only memory (ROM), dynamic RAM (DRAM), synchronous dynamic RAM (SDRAM), static RAM (SRAM), ferroelectric RAM (FeRAM), magnetic RAM (MRAM), resistive RAM (RRAM), flash memory, phase change memory (PCM), self-selecting memory, chalcogenide memory technologies, not-or (NOR) and not-and (NAND) memory devices, and others. Memory cells may be described in terms of volatile configurations or non-volatile configurations. Memory cells configured in a non-volatile configuration may maintain stored logic states for extended periods of time even in the absence of an external power source. Memory cells configured in a volatile configuration may lose stored states when disconnected from an external power source.

### BRIEF DESCRIPTION OF THE DRAWINGS

FIG. 1 shows an example of a memory array that supports a single etch and pier merge method for cell and comb features in accordance with examples as disclosed herein.
FIG. 2 shows a top view of an example of a memory array that supports a single etch and pier merge method for cell and comb features in accordance with examples as disclosed herein.
FIGs. 3A and 3B show side views of an example of a memory array that supports a single etch and pier merge method for cell and comb features in accordance with examples as disclosed herein.
FIGs. 4 through 9 show examples of processing steps of a single etch and pier merge method for cell and comb features in accordance with examples as disclosed herein.
FIG. 10 shows examples of cross-sectional views that support single etch and pier merge method for cell and comb features in accordance with examples as disclosed herein.
FIGs. 11A and 11B show examples of elevation views that supports a single etch and pier merge method for cell and comb features in accordance with examples as disclosed herein.
FIG. 12 shows a flowchart illustrating a method or methods that support single etch and pier merge method for cell and comb features in accordance with examples as disclosed herein.

### DETAILED DESCRIPTION

In some memory architectures, an array of memory cells may be formed by etching a stack of materials multiple times (e.g., at least twice). For example, one or more piers may be patterned and formed in a first processing step that includes a first etching process, and one or more pillars may be patterned and formed in a second processing step that includes a second etching process. The piers may form one or more first access lines (e.g., bit lines) to access memory cells in the array. In such memory architectures, the etching processes may be optimized for circular shapes, resulting in challenges for forming the one or more piers (e.g., which may be generally elliptical shaped) using the first etching process. For example, as the density of memory cells in the array increases, the accuracy of the first etching process along an axis of an elliptical-shaped pier may degrade. That is, methods of forming generally elliptical shaped piers may not scale with higher densities of memory cells. Thus, a method to reliably form generally elliptical shaped piers may be desirable.

The techniques described herein enable one or more pillars and one or more piers to be patterned, aligned, and formed in fewer processing steps (e.g., one processing step) relative to conventional methods. For example, the one or more piers and the one or more pillars may be patterned using a pillar shape (e.g., a circular shape) to form a set of pillar cavities. A first subset of the pillar cavities may be etched such that pairs of pillar cavities merge to form a pier cavity that is filled with a first material and a liner to form the one or more piers. A second subset of the pillar cavities may be filled with the liner and the first material to form the one or more pillars.

In some examples, a third subset of the pillar cavities may be etched such that two or more pillar cavities merge to form a cavity (e.g., a comb edge structure cavity) that is filled with a third material to form one or more comb edge structures. The one or more comb edge structures may form a boundary of a comb structure that corresponds to one or more word lines of the memory array. Based on patterning and etching the one or more pillars and one or more piers using a pillar etch (and subsequently merging adjacent pillar cavities to form pier cavities), the described techniques may support reduced costs in manufacturing memory arrays, as well as an increased scalability for relatively dense memory architectures (e.g., manufacturing techniques may better support forming the elliptical piers by merging circular pillar cavities rather than elliptical cavities).

In addition to applicability in memory systems as described herein, techniques for a single etch and pier merge method for cell and comb features may be generally implemented to improve the sustainability of various electronic devices and systems. As the use of electronic devices has become even more widespread, the amount of energy used and harmful emissions associated with production of electronic devices and device operation has increased. Further, the amount of waste (e.g., electronic waste) associated with disposal of electronic devices may also pose environmental concerns. Implementing the techniques described herein may improve the impact related to electronic devices by patterning and etching one or more piers and one or more pillars in a single processing step (e.g., rather than two) and supporting an increased density in memory cells of a memory array, which may result in lowered production emissions (e.g., by performing fewer manufacturing steps to form the memory array) and reduce electronic waste (e.g., increasing the density of the memory array may increase a quantity of memory cells formed per wafer), among other benefits.

Features of the disclosure are illustrated and described in the context of memory devices and arrays. Features of the disclosure are further illustrated and described in the context of processing steps, cross-sectional views, elevation views, and a flowchart.

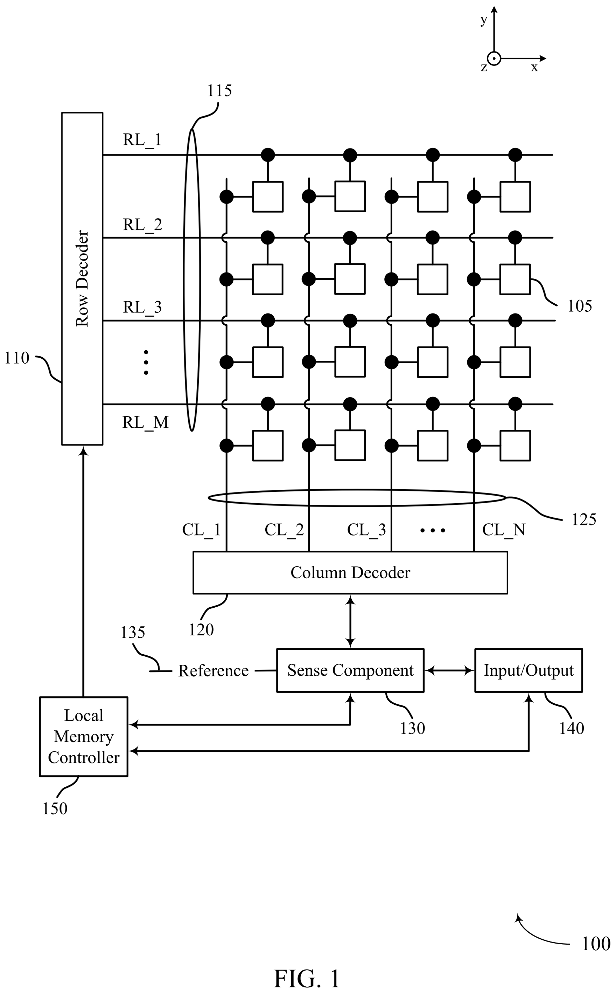

**FIG. 1** shows an example of a memory device 100 that supports a single etch and pier merge method for cell and comb features in accordance with examples as disclosed herein. In some examples, the memory device 100 may be referred to as or include a memory die, a memory chip, or an electronic memory apparatus. The memory device 100 may be operable to provide locations to store information (e.g., physical memory addresses) that may be used by a system (e.g., a host device coupled with the memory device 100, for writing information, for reading information).

The memory device 100 may include one or more memory cells 105 that each may be programmable to store different logic states (e.g., a programmed one of a set of two or more possible states). For example, a memory cell 105 may be operable to store one bit of information at a time (e.g., a logic 0 or a logic 1). In some examples, a memory cell 105 (e.g., a multi-level memory cell 105) may be operable to store more than one bit of information at a time (e.g., a logic 00, logic 01, logic 10, a logic 11). In some examples, the memory cells 105 may be arranged in an array.

A memory cell 105 may store a logic state using a configurable material, which may be referred to as a memory element, a storage element, a memory storage element, a material element, a material memory element, a material portion, or a polarity-written material portion, among others. A configurable material of a memory cell 105 may refer to a chalcogenide-based storage component. For example, a chalcogenide storage element may be used in a phase change memory cell, a thresholding memory cell, or a self-selecting memory cell, among other architectures.

In some examples, the material of a memory cell 105 may include a chalcogenide material or other alloy including selenium (Se), tellurium (Te), arsenic (As), antimony (Sb), carbon (C), germanium (Ge), silicon (Si), or indium (In), or various combinations thereof. In some examples, a chalcogenide material having primarily selenium (Se), arsenic (As), and germanium (Ge) may be referred to as a SAG-alloy. In some examples, a SAG-alloy may also include silicon (Si) and such chalcogenide material may be referred to as SiSAG-alloy. In some examples, SAG-alloy may include silicon (Si) or indium (In) or a combination thereof and such chalcogenide materials may be referred to as SiSAG-alloy or InSAG-alloy, respectively, or a combination thereof. In some examples, the chalcogenide material may include additional elements such as hydrogen (H), oxygen (O), nitrogen (N), chlorine (Cl), or fluorine (F), each in atomic or molecular forms.

In some examples, a memory cell 105 may be an example of a phase change memory cell. In such examples, the material used in the memory cell 105 may be based on an alloy (such as the alloys listed above) and may be operated so as to change to different physical state (e.g., undergo a phase change) during normal operation of the memory cell 105. For example, a phase change memory cell 105 may be associated with a relatively disordered atomic configuration (e.g., a relatively amorphous state) and a relatively ordered atomic configuration (e.g., a relatively crystalline state). A relatively disordered atomic configuration may correspond to a first logic state (e.g., a RESET state, a logic 0) and a relatively ordered atomic configuration may correspond to a second logic state (e.g., a logic state different than the first logic state, a SET state, a logic 1).

In some examples (e.g., for thresholding memory cells 105, for self-selecting memory cells 105), some or all of the set of logic states supported by the memory cells 105 may be associated with a relatively disordered atomic configuration of a chalcogenide material (e.g., the material in an amorphous state may be operable to store different logic states). In some examples, the storage element of a memory cell 105 may be an example of a self-selecting storage element. In such examples, the material used in the memory cell 105 may be based on an alloy (e.g., such as the alloys listed above) and may be operated so as to undergo a change to a different physical state during normal operation of the memory cell 105. For example, a self-selecting or thresholding memory cell 105 may have a high threshold voltage state and a low threshold voltage state, where a corresponding "threshold voltage" may refer to a voltage at which or above which the memory cell 105 transitions from a relatively higher-resistance (e.g., non-conductive) state to a relatively lower-resistance (e.g., conductive) state, such as in response to an applied voltage. A high threshold voltage state may correspond to a first logic state (e.g., a RESET state, a logic 0) and a low threshold voltage state may correspond to a second logic state (e.g., a logic state different than the first logic state, a SET state, a logic 1).

During a write operation (e.g., a programming operation) of a self-selecting or thresholding memory cell 105, a polarity used for a write operation may influence (e.g., determine, set, program) a behavior or characteristic of the material of the memory cell 105, such as a thresholding characteristic (e.g., a threshold voltage) of the material. A difference between thresholding characteristics (e.g., resistivity characteristics, conductivity characteristics) of the material of the memory cell 105 for different logic states stored by the material of the memory cell 105 (e.g., a difference between threshold voltages when the material is storing a logic state '0' versus a logic state '1') may correspond to the read window of the memory cell 105.

The memory device 100 may include access lines (e.g., row lines 115 each extending along an illustrative x-direction, column lines 125 each extending along an illustrative y-direction) arranged in a pattern, such as a grid-like pattern. Access lines may be formed with one or more conductive materials. In some examples, row lines 115, or some portion thereof, may be referred to as word lines. In some examples, column lines 125, or some portion thereof, may be referred to as digit lines or bit lines. References to access lines, or their analogues, are interchangeable without loss of understanding. Memory cells 105 may be positioned at intersections of access lines, such as row lines 115 and the column lines 125. In some examples, memory cells 105 may also be arranged (e.g., addressed) along an illustrative z-direction, such as in an implementation of sets of memory cells 105 being located at different levels (e.g., layers, decks, planes, tiers) along the illustrative z-direction. In some examples, a memory device 100 that includes memory cells 105 at different levels may be supported by a different configuration of access lines, decoders, and other supporting circuitry than shown.

Operations such as read operations and write operations may be performed on the memory cells 105 by activating access lines such as one or more of a row line 115 or a column line 125, among other access lines associated with alternative configurations. For example, by activating a row line 115 and a column line 125 (e.g., applying a voltage to the row line 115 or the column line 125), a memory cell 105 may be accessed in accordance with their intersection. An intersection of a row line 115 and a column line 125, among other access lines, in various two-dimensional or three-dimensional configuration may be referred to as an address of a memory cell 105. In some examples, an access line may be a conductive line coupled with a memory cell 105 and may be used to perform access operations on the memory cell 105. In some examples, the memory device 100 may perform operations responsive to commands, which may be issued by a host device coupled with the memory device 100 or may be generated by the memory device 100 (e.g., by a local memory controller 150).

Accessing the memory cells 105 may be controlled through one or more decoders, such as a row decoder 110 or a column decoder 120, among other examples. For example, a row decoder 110 may receive a row address from the local memory controller 150 and activate a row line 115 based on the received row address. A column decoder 120 may receive a column address from the local memory controller 150 and may activate a column line 125 based on the received column address.

The sense component 130 may be operable to detect a state (e.g., a material state, a resistance state, a threshold state) of a memory cell 105 and determine a logic state of the memory cell 105 based on the detected state. The sense component 130 may include one or more sense amplifiers to convert (e.g., amplify) a signal resulting from accessing the memory cell 105 (e.g., a signal of a column line 125 or other access line). The sense component 130 may compare a signal detected from the memory cell 105 to a reference 135 (e.g., a reference voltage, a reference charge, a reference current). The detected logic state of the memory cell 105 may be provided as an output of the sense component 130 (e.g., to an input/output component 140), and may indicate the detected logic state to another component of the memory device 100 or to a host device coupled with the memory device 100.

The local memory controller 150 may control the accessing of memory cells 105 through the various components (e.g., a row decoder 110, a column decoder 120, a sense component 130, among other components). In some examples, one or more of a row decoder 110, a column decoder 120, and a sense component 130 may be co-located with the local memory controller 150. The local memory controller 150 may be operable to receive information (e.g., commands, data) from one or more different controllers (e.g., an external memory controller associated with a host device, another controller associated with the memory device 100), translate the information into a signaling that can be used by the memory device 100, perform one or more operations on the memory cells 105 and communicate data from the memory device 100 to a host device based on performing the one or more operations. The local memory controller 150 may generate row address signals and column address signals to activate access lines such as a target row line 115 and a target column line 125. The local memory controller 150 also may generate and control various signals (e.g., voltages, currents) used during the operation of the memory device 100. In general, the amplitude, the shape, or the duration of an applied signal discussed herein may be varied and may be different for the various operations discussed in operating the memory device 100.

The local memory controller 150 may be operable to perform one or more access operations on one or more memory cells 105 of the memory device 100. Examples of access operations may include a write operation, a read operation, a refresh operation, a precharge operation, or an activate operation, among others. In some examples, access operations may be performed by or otherwise coordinated by the local memory controller 150 in response to access commands (e.g., from a host device). The local memory controller 150 may be operable to perform other access operations not listed here or other operations related to the operating of the memory device 100 that are not directly related to accessing the memory cells 105.

In some memory architectures, an array of memory cells 105 may be formed by etching a stack of materials multiple times (e.g., at least twice). For example, one or more piers may be patterned and formed in a first processing step that includes a first etching process, and one or more pillars may be patterned and formed in a second processing step that includes a second etching process. The piers may form one or more first access lines (e.g., bit lines or column lines 125) to access memory cells 105 in the array. In such memory architectures, the etching processes may be optimized for circular shapes, resulting in challenges for forming the one or more piers (e.g., which may be generally elliptical shaped) using the first etching process. For example, as the density of memory cells 105 in the array increases, the accuracy of the first etching process along an axis of an elliptical pier may degrade. That is, methods of forming generally elliptical shaped piers may not scale with higher densities of memory cells 105. Thus, a method to reliably form generally elliptical shaped piers may be desirable.

The memory device 100 may include one or more pillars and one or more piers that are patterned, aligned, and formed in fewer processing steps (e.g., one processing step) relative to conventional methods. For example, the one or more piers and the one or more pillars may be patterned using a pillar shape (e.g., a circular shape) to form a set of pillar cavities. A first subset of the pillar cavities may be etched such that pairs of pillar cavities merge to form a pier cavity that is filled with a first material and a liner to form the one or more piers. A second subset of the pillar cavities may be filled with the liner and the first material to form the one or more pillars.

In some examples, a third subset of the pillar cavities may be etched such that two or more pillar cavities merge to form a cavity (e.g., a comb edge structure cavity) that is filled with a third material to form one or more comb edge structures. The one or more comb edge structures may form a boundary of a comb structure that corresponds to one or more word lines (e.g., row lines 115) of the memory array. Based on patterning and etching the one or more pillars and one or more piers using a pillar etch (and subsequently merging adjacent pillar cavities to form pier cavities), the described techniques may support reduced costs in manufacturing arrays of memory cells 105 as well as an increased scalability for relatively dense memory architectures (e.g., manufacturing techniques may better support forming the elliptical piers by merging circular pillar cavities rather than elliptical cavities).

The memory device 100 may include any quantity of non-transitory computer readable media that support single etch and pier merge method for cell and comb features. For example, a local memory controller 150, a row decoder 110, a column decoder 120, a sense component 130, or an input/output component 140, or any combination thereof may include or may access one or more non-transitory computer readable media storing instructions (e.g., firmware) for performing the functions ascribed herein to the memory device 100. For example, such instructions, if executed by the memory device 100, may cause the memory device 100 to perform one or more associated functions as described herein.

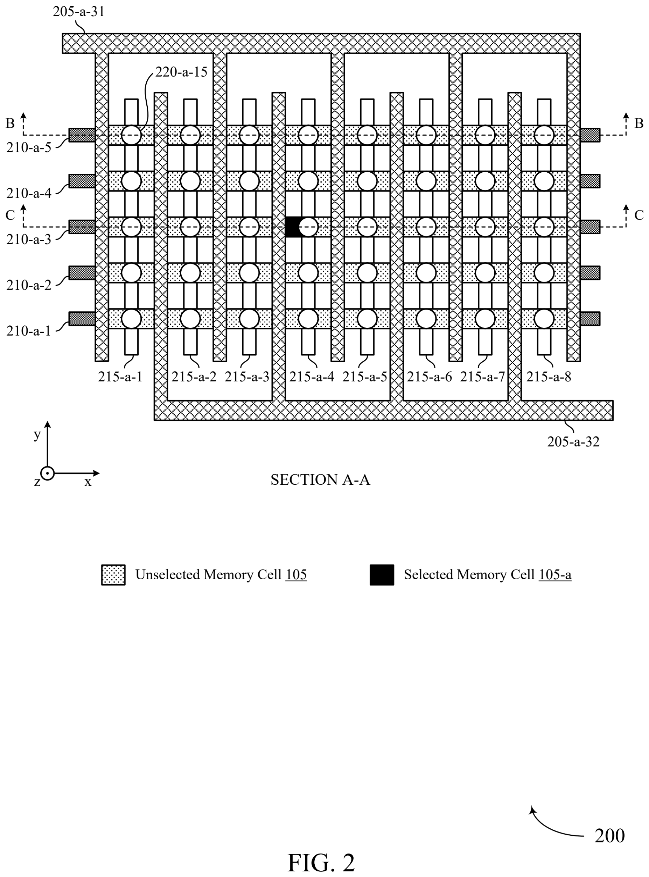

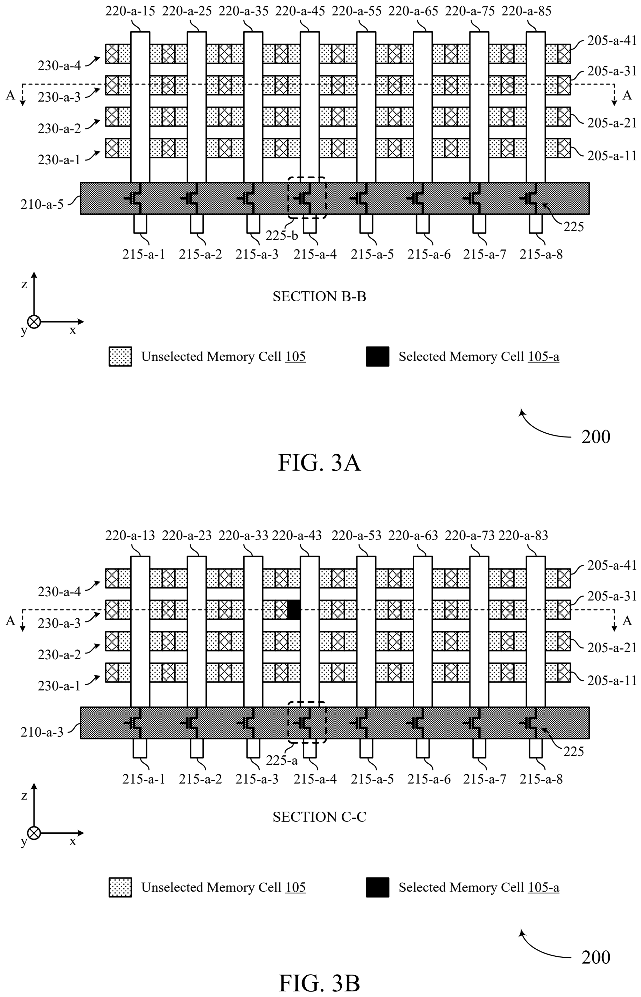

**FIGs. 2****,** **3A, and 3B** show an example of a memory array 200 that supports a single etch and pier merge method for cell and comb features in accordance with examples as disclosed herein. The memory array 200 may be included in a memory device 100, and illustrates an example of a three-dimensional arrangement of memory cells 105 that may be accessed by various conductive structures (e.g., access lines). FIG. 2 illustrates a top section view (e.g., SECTION A-A) of the memory array 200 relative to a cut plane A-A as shown in FIGs. 3A and 3B. FIG. 3A illustrates a side section view (e.g., SECTION B-B) of the memory array 200 relative to a cut plane B-B as shown in FIG. 2. FIG. 3B illustrates a side section view (e.g., SECTION C-C) of the memory array 200 relative to a cut plane C-C as shown in FIG. 2. The section views may be examples of cross-sectional views of the memory array 200 with some aspects (e.g., dielectric structures) removed for clarity. Elements of the memory array 200 may be described relative to an x-direction, a y-direction, and a z-direction, as illustrated in each of FIGs. 2, 3A, and 3B. Although some elements included in FIGs. 2, 3A, and 3B are labeled with a numeric indicator, other corresponding elements are not labeled, although they are the same or would be understood to be similar, in an effort to increase visibility and clarity of the depicted features. Further, although some quantities of repeated elements are shown in the illustrative example of memory array 200, techniques in accordance with examples as described herein may be applicable to any quantity of such elements, or ratios of quantities between one repeated element and another.

In the example of memory array 200, memory cells 105 and word lines 205 may be distributed along the z-direction according to levels 230 (e.g., decks, layers, planes, tiers, as illustrated in FIGs. 3A and 3B). In some examples, the z-direction may be orthogonal to a substrate (not shown) of the memory array 200, which may be below the illustrated structures along the z-direction. Although the illustrative example of memory array 200 includes four levels 230, a memory array 200 in accordance with examples as disclosed herein may include any quantity of one or more levels 230 (e.g., 64 levels, 128 levels) along the z-direction.

Each word line 205 may be an example of a portion of an access line that is formed by one or more conductive materials (e.g., one or more metal portions, one or more metal alloy portions). As illustrated, a word line 205 may be formed in a comb structure, including portions (e.g., projections, tines) extending along the y-direction through gaps (e.g., alternating gaps) between pillars 220. For example, as illustrated, the memory array 200, may include two word lines 205 per level 230 (e.g., according to odd word lines 205-a-*n*1 and even word lines 205-a-*n*2 for a given level, n), where such word lines 205 of the same level 230 may be described as being interleaved (e.g., with portions of an odd word line 205-a-*n*1 projecting along the y-direction between portions of an even word line 205-a-*n*2, and vice versa). In some examples, an odd word line 205 (e.g., of a level 230) may be associated with a first memory cell 105 on a first side (e.g., along the x-direction) of a given pillar 220 and an even word line (e.g., of the same level 230) may be associated with a second memory cell 105 on a second side (e.g., along the x-direction, opposite the first memory cell 105) of the given pillar 220. Thus, in some examples, memory cells 105 of a given level 230 may be addressed (e.g., selected, activated) in accordance with an even word line 205 or an odd word line 205.

Each pillar 220 may be an example of a portion of an access line (e.g., a conductive pillar portion) that is formed by one or more conductive materials (e.g., one or more metal portions, one or more metal alloy portions). As illustrated, the pillars 220 may be arranged in a two-dimensional array (e.g., in an xy-plane) having a first quantity of pillars 220 along a first direction (e.g., eight pillars along the x-direction, eight rows of pillars), and having a second quantity of pillars 220 along a second direction (e.g., five pillars along the y-direction, five columns of pillars). Although the illustrative example of memory array 200 includes a two-dimensional arrangement of eight pillars 220 along the x-direction and five pillars 220 along the y-direction, a memory array 200 in accordance with examples as disclosed herein may include any quantity of pillars 220 along the x-direction and any quantity of pillars 220 along the y-direction. Further, as illustrated, each pillar 220 may be coupled with a respective set of memory cells 105 (e.g., along the z-direction, one or more memory cells 105 for each level 230). A pillar 220 may have a cross-sectional area in an xy-plane that extends along the z-direction. Although illustrated with a circular cross-sectional area in the xy-plane, a pillar 220 may be formed with a different shape, such as having an elliptical, square, rectangular, polygonal, or other cross-sectional area in an xy-plane.

The memory cells 105 each may include a chalcogenide material. In some examples, the memory cells 105 may be examples of thresholding memory cells. Each memory cell 105 may be accessed (e.g., addressed, selected) according to an intersection between a word line 205 (e.g., a level selection, which may include an even or odd selection within a level 230) and a pillar 220. For example, as illustrated, a selected memory cell 105-a of the level 230-a-3 may be accessed according to an intersection between the pillar 220-a-43 and the word line 205-a-32.

A memory cell 105 may be accessed (e.g., written to, read from) by applying an access bias (e.g., an access voltage, V_{access}, which may be a positive voltage or a negative voltage) across the memory cell 105. In some examples, an access bias may be applied by biasing a selected word line 205 with a first voltage (e.g., V_{access}/2) and by biasing a selected pillar 220 with a second voltage (e.g., -V_{access}/2), which may have an opposite sign relative to the first voltage. Regarding the selected memory cell 105-a, a corresponding access bias (e.g., the first voltage) may be applied to the word line 205-a-32, while other unselected word lines 205 may be grounded (e.g., biased to 0V). In some examples, a word line bias may be provided by a word line driver (not shown) coupled with one or more of the word lines 205.

To apply a corresponding access bias (e.g., the second voltage) to a pillar 220, the pillars 220 may be configured to be selectively coupled with a sense line 215 (e.g., a digit line, a column line, an access line extending along the y-direction) via a respective transistor 225 coupled between (e.g., physically, electrically) the pillar 220 and the sense line 215. In some examples, the transistors 225 may be vertical transistors (e.g., transistors having a channel along the z-direction, transistors having a semiconductor junction along the z-direction), which may be formed above the substrate of the memory array 200 using various techniques (e.g., thin film techniques). In some examples, a selected pillar 220, a selected sense line 215, or a combination thereof may be an example of a selected column line 125 described with reference to FIG. 1 (e.g., a bit line).

The transistors 225 (e.g., a channel portion of the transistors 225) may be activated by gate lines 210 (e.g., activation lines, selection lines, a row line, an access line extending along the x-direction) coupled with respective gates of a set of the transistors 225 (e.g., a set along the x-direction). In other words, each of the pillars 220 may have a first end (e.g., towards the negative z-direction, a bottom end) configured for coupling with an access line (e.g., a sense line 215). In some examples, the gate lines 210, the transistors 225, or both may be considered to be components of a row decoder 110 (e.g., as pillar decoder components). In some examples, the selection of (e.g., biasing of) pillars 220, or sense lines 215, or various combinations thereof, may be supported by a column decoder 120, or a sense component 130, or both.

To apply the corresponding access bias (e.g., -V_{access}/2) to the pillar 220-a-43, the sense line 215-a-4 may be biased with the access bias, and the gate line 210-a-3 may be grounded (e.g., biased to 0V) or otherwise biased with an activation voltage. In an example where the transistors 225 are n-type transistors, the gate line 210-a-3 being biased with a voltage that is relatively higher than the sense line 215-a-4 may activate the transistor 225-a (e.g., cause the transistor 225-a to operate in a conducting state), thereby coupling the pillar 220-a-43 with the sense line 215-a-4 and biasing the pillar 220-a-43 with the associated access bias. However, the transistors 225 may include different channel types, or may be operated in accordance with different biasing schemes, to support various access operations.

In some examples, unselected pillars 220 of the memory array 200 may be electrically floating when the transistor 225-a is activated, or may be coupled with another voltage source (e.g., grounded, via a high-resistance path, via a leakage path) to avoid a voltage drift of the pillars 220. For example, a ground voltage being applied to the gate line 210-a-3 may not activate other transistors coupled with the gate line 210-a-3, because the ground voltage of the gate line 210-a-3 may not be greater than the voltage of the other sense lines 215 (e.g., which may be biased with a ground voltage or may be floating). Further, other unselected gate lines 210, including gate line 210-a-5 as shown in FIG. 3A, may be biased with a voltage equal to or similar to an access bias (e.g., -V_{access}/2, or some other negative bias or bias relatively near the access bias voltage), such that transistors 225 along an unselected gate line 210 are not activated. Thus, the transistor 225-b coupled with the gate line 210-a-5 may be deactivated (e.g., operating in a non-conductive state), thereby isolating the voltage of the sense line 215-a-4 from the pillar 220-a-45, among other pillars 220.

In a write operation, a memory cell 105 may be written to by applying a write bias (e.g., where V_{access} = V_{write}, which may be a positive voltage or a negative voltage) across the memory cell 105. In some examples, a polarity of a write bias may influence (e.g., determine, set, program) a behavior or characteristic of the material of the memory cell 105, such as the threshold voltage of the material. For example, applying a write bias with a first polarity may set the material of the memory cell 105 with a first threshold voltage, which may be associated with storing a logic 0. Further, applying a write bias with a second polarity (e.g., opposite the first polarity) may set the material of the memory cell with a second threshold voltage, which may be associated with storing a logic 1. A difference between threshold voltages of the material of the memory cell 105 for different logic states stored by the material of the memory cell 105 (e.g., a difference between threshold voltages when the material is storing a logic state '0' versus a logic state '1') may correspond to the read window of the memory cell 105.

In a read operation, a memory cell 105 may be read from by applying a read bias (e.g., where V_{access} = V_{read}, which may be a positive voltage or a negative voltage) across the memory cell 105. In some examples, a logic state of the memory cell 105 may be evaluated based on whether the memory cell 105 thresholds (e.g., transitions to a relatively lower-resistance or conductive state, permits current) in the presence of the applied read bias. For example, such a read bias may cause a memory cell 105 storing a first logic state (e.g., a logic 0) to threshold (e.g., permit a current flow, permit a current above a threshold current), and may not cause a memory cell 105 storing a second logic state (e.g., a logic 1) to threshold (e.g., may not permit a current flow, may permit a current below a threshold current).

In some memory architectures, a memory array 200 of memory cells 105 may be formed by etching a stack of materials multiple times (e.g., at least twice). For example, one or more piers may be patterned and formed in a first processing step that includes a first etching process, and one or more pillars 220 may be patterned and formed in a second processing step that includes a second etching process. The piers may form one or more first access lines (e.g., bit lines) to access memory cells 105 in the memory array 200. In such memory architectures, the etching processes may be optimized for circular shapes, resulting in challenges for forming the one or more piers (e.g., which may be generally elliptical shaped) using the first etching process. For example, as the density of memory cells 105 in the memory array 200 increases, the accuracy of the first etching process along an axis of an elliptical-shaped pier may degrade. That is, methods of forming generally elliptical shaped piers may not scale with higher densities of memory cells 105. Thus, a method to reliably form generally elliptical shaped piers may be desirable.

The memory array 200 described herein may enable one or more pillars 220 and one or more piers to be patterned, aligned, and formed in fewer processing steps (e.g., one processing step) relative to conventional methods. For example, the one or more piers and the one or more pillars 220 may be patterned using a pillar shape (e.g., a circular shape) to form a set of pillar cavities. A first subset of the pillar cavities may be etched such that pairs of pillar cavities merge to form a pier cavity that is filled with a first material and a liner to form the one or more piers. A second subset of the pillar cavities may be filled with the liner and the first material to form the one or more pillars 220.

In some examples, a third subset of the pillar cavities may be etched such that two or more pillar cavities merge to form a cavity (e.g., a comb edge structure cavity) that is filled with a third material to form one or more comb edge structures. The one or more comb edge structures may form a boundary of a comb structure that corresponds to one or more word lines 205 of the memory array 200. Based on patterning and etching the one or more pillars 220 and one or more piers using a pillar etch (and subsequently merging adjacent pillar cavities to form pier cavities), the described techniques may support reduced costs in manufacturing the memory array 200 as well as an increased scalability for relatively dense memory architectures (e.g., manufacturing techniques may better support forming the elliptical piers by merging circular pillar cavities rather than elliptical cavities).

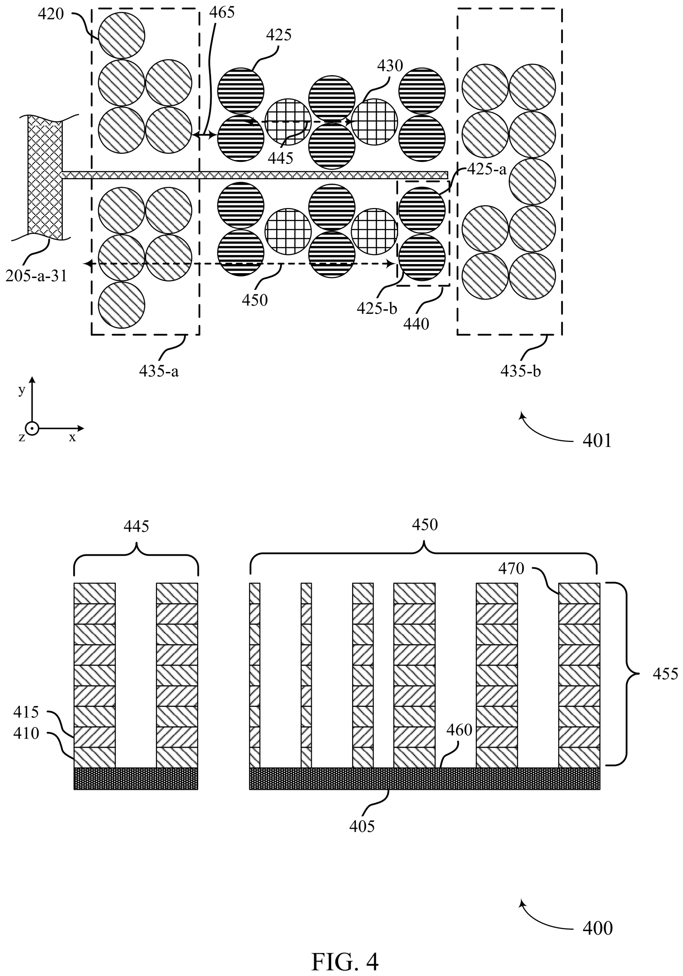

**FIG.** 4 shows an example of a first processing step 400 that supports a single etch and pier merge method for cell and comb features in accordance with examples as disclosed herein. The first processing step 400 illustrates a top plan view 401, a first cross-sectional view 445, and a second cross-sectional view 450 of materials on a substrate 405. The cross-sections depicted in FIG. 4 may be denoted by the corresponding lines in the top plan view 401.

In the first processing step 400, a stack 455 of materials may be formed on the substrate 405. The stack 455 may include a first material 410 and a second material 415 in alternating layers. In some examples, the first material 410 may include a nitride material (e.g., silicon nitride) and the second material 415 may include an oxide material (e.g., silicon dioxide). In some examples, the first material 410 may include a polysilicon material or a tungsten material. Any quantity of layers may be included (e.g., layered) based on a desired height of the vertical stack of memory cells in a memory array (e.g., the memory array 200). The stack 455 of materials (e.g., the first material 410 and the second material 415) may be etched (e.g., removed) to form multiple pillar cavities through the stack 455 of materials and up to a surface 460 of the substrate 405. That is, the first processing step 400 may include forming, through the stack 455 of materials that includes alternating layers of the first material 410 and the second material 415, the multiple pillar cavities.

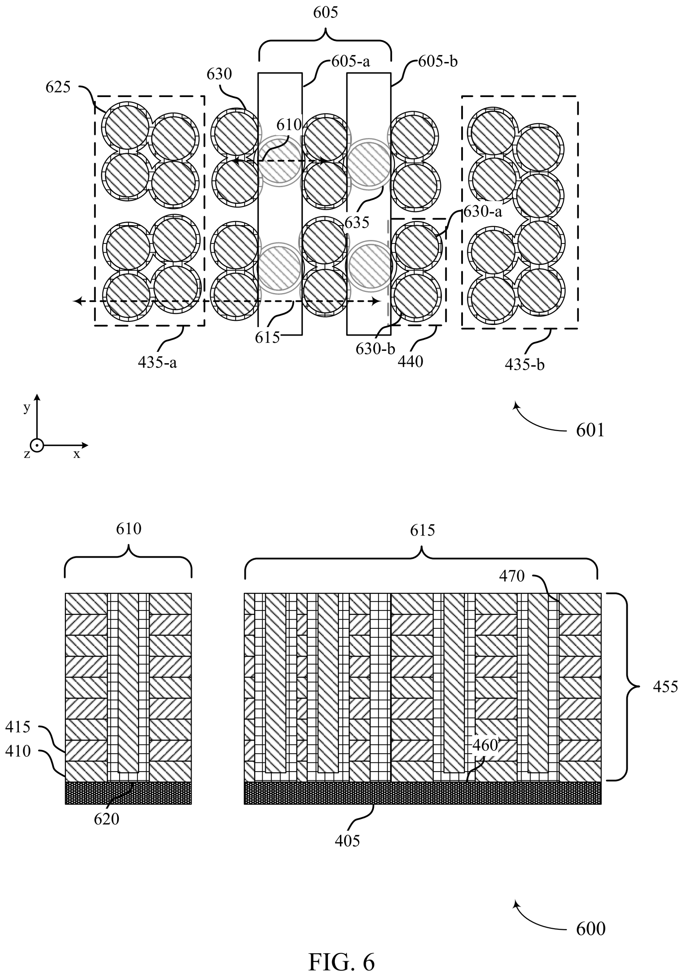

As described herein, etching may be a process used to remove one or more layers from the surface of a material (e.g., the first material 410 and/or the second material 415). In some examples, an etching process may include forming cavities, and the cavities may define areas where materials (e.g., the first material 410 and/or the second material 415) may be deposited to create structures, such as the pillars 220 (or the set of pillars 635 described with reference to FIG. 6) or a set of piers 440. The etching process may use chemical and/or physical methods to selectively remove materials. For example, the etching process to form the multiple pillar cavities in the stack 455 of materials may include a dry etch, a wet etch, a sequence of the dry etch and the wet etch, or any combination thereof. In some examples, the first processing step 400 may include etching the stack 455 in accordance with a pattern (e.g., using a pillar template) to form the multiple pillar cavities. That is, the etching process may form the shape and depth of the cavities based on the shape and depth of a pillar, such as the one or more pillars 220 described with reference to FIGs. 2 and 3.

The multiple pillar cavities may include a first set of pillar cavities 420 associated with one or more comb edge structures 435, a second set of pillar cavities 425 associated with one or more piers 440 (e.g., the set of piers 440), and a third set of pillar cavities 430 associated with one or more pillars (e.g., one or more pillars 220). The one or more piers 440 and one or more pillars may be associated with the memory array 200. As described herein, it may be understood that the second set of pillar cavities 425 and the third set of pillar cavities 430 may extend in a repeating pattern in an x direction and/or a y direction between the comb edge structures 435. For example, although three columns of the second set of pillar cavities 425 and two columns of the third set of pillar cavities 430 are illustrated in FIG. 4, it may be understood that any quantity of columns of the second set of pillar cavities 425 and the third set of pillar cavities 430 may be distributed between the first comb edge structure 435-a and the second comb edge structure 435-b.

In some examples, a first subset of the first set of pillar cavities 420 may be associated with a first comb edge structure 435-a and a second subset of the first set of pillar cavities 420 may be associated with a second comb edge structure 435-b. The comb edge structures 435 may form a boundary of one or more comb structures (e.g., the serpentine comb structure illustrated in FIG. 2). In some examples, the one or more comb structures may correspond to one or more word lines 205 in the memory array 200, such as a word line 205-a-31 shown in FIG. 4 and also shown and described with reference to FIG. 2. A respective pier 440 may be associated with two pillar cavities of the second set of pillar cavities 425. For example, a pier of the set of piers 440 may be formed based on a first pillar cavity 425-a of the second set of pillar cavities 425 and a second pillar cavity 425-b of the second set of pillar cavities 425. In some examples, a respective pillar cavity of the third set of pillar cavities 430 may be associated with a pillar (e.g., a pillar 220).

In some examples, the multiple pillar cavities may be etched such that a spacing 465 between respective pillar cavities satisfies one or more design thresholds. For example, the pillar cavities may be etched such that cross-talk (e.g., noise or interference) between the set of pillars, set of piers 440, or comb edge structures 435 formed from the multiple pillar cavities is below a threshold (e.g., based on the size of the spacing 465). In another example, the multiple pillar cavities may be etched such that the spacing 465 satisfies a sidewall 470 thickness threshold based on a second etching process, as described with reference to FIG. 6 (e.g., such that the multiple pillar cavities do not merge in the first processing step 400).

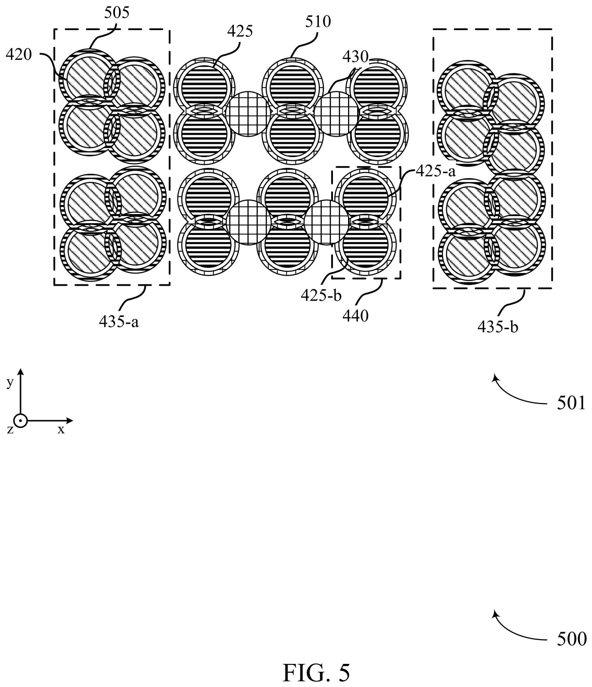

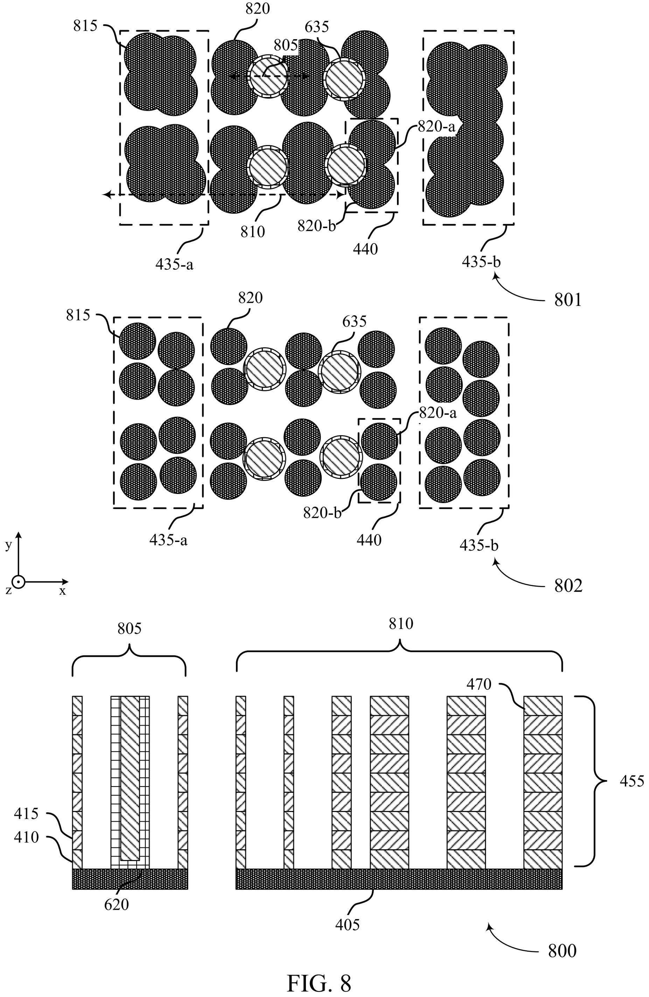

**FIG. 5** shows an example of a second processing step 500 that supports a single etch and pier merge method for cell and comb features in accordance with examples as disclosed herein. The second processing step 500 illustrates a top plan view 501 (e.g., at a respective layer of the second material 415 in the stack 455) of first portions 505 for performing a symmetrical etch around each cavity of the first set of pillar cavities 420 such that one or more pillar cavities of the first set of pillar cavities 420 merge. That is, a respective pillar cavity may merge with at least a second pillar cavity to form a larger (e.g., compared to any single pillar cavity) cavity (e.g., a comb edge structure cavity 815 described with reference to FIG. 8).

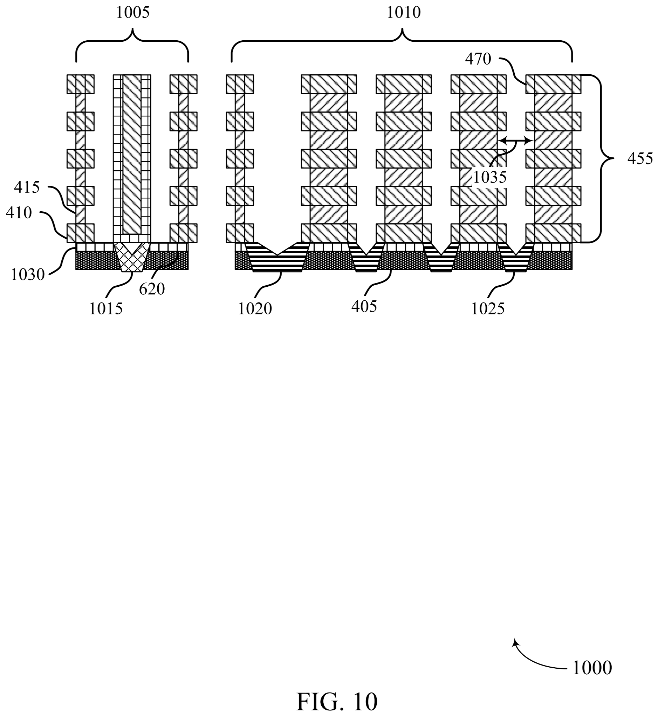

The top plan view 501 also illustrates second portions 510 for performing a symmetrical etch around each cavity of the second set of pillar cavities 425 such that two or more pillar cavities of the second set of pillar cavities 425 merge. For example, a first pillar cavity 425-a and a second pillar cavity 425-b may both be etched by the second portion 510 such that the first and second pillar cavities merge to form a respective pier cavity (e.g., a pier cavity 820 described with reference to FIG. 8). Based on forming the set of piers 440 via the second set of pillar cavities 425, the described techniques may reduce a quantity of etch processing steps, thereby decreasing production costs associated with the memory array 200 and reducing alignment issues between pier and pillar features. As described further with reference to FIG. 10 the first portions 505 and the second portions 510 may be etched at layers of the second material 415 in the stack 455 (e.g., and not at layers of the first material 410).

**FIG.** 6 shows an example of a third processing step 600 that supports a single etch and pier merge method for cell and comb features in accordance with examples as disclosed herein. The third processing step 600 illustrates a top plan view 601 (e.g., at a respective layer of the second material 415 in the stack 455), a first cross-sectional view 610, and a second cross-sectional view 615 of materials on the substrate 405. The cross-sections depicted in FIG. 6 may be denoted by the corresponding lines in the top plan view 601.

In the third processing step 600, a first liner 620 may be deposited in the first set of pillar cavities 420, the second set of pillar cavities 425, and in the third set of pillar cavities 430 described with reference to FIGs. 4 and 5. For example, the first liner 620 may be deposited onto the surface 460 of the substrate 405. Additionally, or alternatively, the first liner 620 may cover some or all of the sidewalls 470 of each of the pillar cavities. In some cases, the first liner 620 may be deposited using chemical vapor deposition (CVD), physical vapor deposition (PVD), atomic layer deposition (ALD), or any combination thereof.

In some examples, the first liner 620 may include a silicon carbon nitride material (e.g., SiCN). The first liner 620 may protect or insulate other layers (e.g., layers of the first material 410 and/or the second material 415) during etching processes described herein. Based on depositing the first liner 620 in each of the pillar cavities, the first material 410 (e.g., a nitride material or core) may be deposited to fill each of the pillar cavities with the first liner 620, as illustrated in the first cross-sectional view 610 (e.g., of an eventual pillar 220) and in the second cross-sectional view 615 (e.g., of an eventual comb edge structure and two piers of the set of piers 440). Additionally, or alternatively, the second material 415 (e.g., an oxide material) may be deposited to fill each of the pillar cavities with the first liner 620. In some examples, the first material 410 or the second material 415 may include a polysilicon material or tungsten material (e.g., the pillar cavities may be filled with a polysilicon core or a tungsten core). That is, the pillar cavities may be filled with any core material that may be exhumed selective to the first liner 620 and/or the surrounding materials (e.g., oxide and/or nitride materials).

The first liner 620 and the first material 410 may be deposited to fill each of the pillar cavities and may form a first set of pillars 625 associated with the one or more comb edge structures 435, a second set of pillars 630 associated with one or more piers 440, and a third set of pillars 635. That is, the third processing step 600 may include depositing the first liner 620 and the first material 410 in each of the multiple pillar cavities to form the one or more pillars 635 within the third set of pillar cavities 430. In some examples, a first subset of the first set of pillars 625 may be associated with the first comb edge structure 435-a and a second subset of the first set of pillars 625 may be associated with the second comb edge structure 435-b. In another example, each of the one or more piers 440 may be associated with two pillars of the second set of pillars 630. For example, a first pillar 630-a and a second pillar 630-b of the second set of pillars 630 may be associated with a pier 440.

The third processing step 600 may include applying a first mask 605 (e.g., a first masking material) to the one or more pillars 635 (e.g., to the third set of pillars 635). The first mask 605 may include multiple portions that cover each pillar of the third set of pillars 635 (e.g., and not the first set of pillars 625 or second set of pillars 630). For example, a first portion 605-a of the first mask 605 may cover (e.g., be above) a first column of pillars 635 and a second portion 605-b of the first mask 605 may cover (e.g., be above) a second column of pillars 635. In some examples, the first mask 605 may include a carbon film material that may not be sensitive to etch chemistries used for etching the first material 410 (e.g., and/or the second material 415). That is, the first mask 605 may protect the first liner 620 and the first material 410 from being etched in the third set of pillars 635 (e.g., or at least protect against a substantial portion of the first liner 620 or the first material from being etched). Although two portions of the first mask 605 are illustrated in the third processing step 600, it may be understood that the first mask 605 may apply to each pillar 635 of the memory array 200.

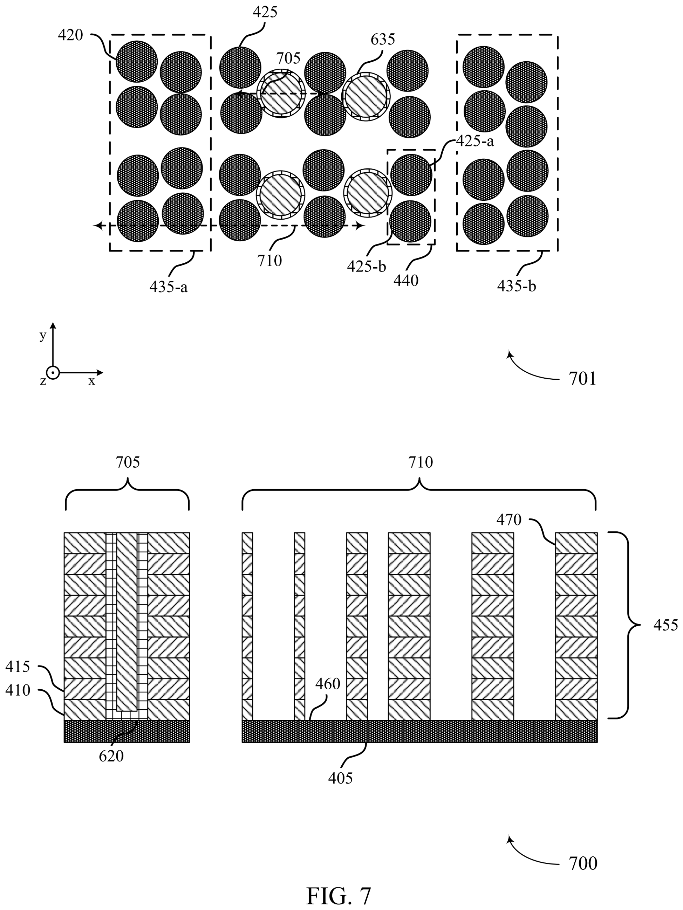

**FIG. 7** shows an example of a fourth processing step 700 that supports a single etch and pier merge method for cell and comb features in accordance with examples as disclosed herein. The fourth processing step 700 illustrates a top plan view 701 (e.g., at a respective layer of the second material 415 in the stack 455), a first cross-sectional view 705, and a second cross-sectional view 710 of materials on the substrate 405. The cross sections depicted in FIG. 7 may be denoted by the corresponding lines in the top plan view 701.

The fourth processing step 700 may include removing (e.g., exhuming), based on the first mask 605 material, the first liner 620 and the first material 410 from the first set of pillars 625 and the second set of pillars 630, as illustrated in the second cross-sectional view 710. That is, for each pillar of the first set of pillars 625 and for each pillar of the second set of pillars 630, the first material 410 and the first liner 620 may be exhumed. For example, the first liner 620 and the first material 410 may be removed from the stack 455 of materials and expose the surface 460 of the substrate and the sidewalls 470 in each of the first set of pillars 625 and the second set of pillars 630. In some examples, the first material 410 (e.g., and/or the second material 415) in the first set of pillars 625 and the second set of pillars 630 may be removed using a first etch process, such as a wet etching process (e.g., to remove the nitride core). In some other examples, the first material 410 (e.g., and/or the second material 415) may be removed using a vapor etching process. The first liner 620 may be removed using a second etch process, such as the vapor etching process.

The first set of pillar cavities 420 may be re-formed (e.g., re-formed, formed for a subsequent time) based on removing the first liner 620 and the first material 410 from the first set of pillars 625. Additionally, the second set of pillar cavities 425 may be re-formed based on removing the first liner 620 and the first material 410 from the second set of pillars 630. In some examples, the first set of pillar cavities 420 may be re-formed at a different time than the second set of pillar cavities 425 (e.g., the first set of pillars 625 may be etched in a separate etching process from the second set of pillars 630). As illustrated in the first cross-sectional view 610, the first mask 605 (e.g., illustrated in FIG. 6) may protect the first material 410 and the first liner 620 in the third set of pillars 635 from being removed by the etching processes (e.g., the wet etch and/or the vapor etch).

**FIG. 8** shows an example of a fifth processing step 800 that supports a single etch and pier merge method for cell and comb features in accordance with examples as disclosed herein. The fifth processing step 800 illustrates a first top plan view 801 at a respective layer of the second material 415 in the stack 455, a second top plan view 802 at a respective layer of the first material 410 in the stack 455, a first cross-sectional view 805, and a second cross-sectional view 810 of materials on the substrate 405. The cross-sections depicted in FIG. 8 may be denoted by the corresponding lines in the first top plan view 801.

In the fifth processing step 800, at least a portion (e.g., the first planned portion 505) of each of the first set of pillar cavities 420 and at least a portion (e.g., the second portion 510) of each of the second set of pillar cavities 425 may be removed to form a set of comb edge structure cavities 815 and a set of pier cavities 820, respectively. That is, the fifth processing step 800 may include merging (e.g., at respective layers of the second material 415 in the stack 455) two or more adjacent pillar cavities of the first set of pillar cavities 420 based on removing the portion of the second material 415 in the first set of pillar cavities 420. The one or more comb edge structures 435 may be formed based on merging the two or more adjacent pillar cavities.

In some examples, the fifth processing step 800 may remove at least the portion of the second material 415 in the first set of pillar cavities 420 based on removing the first liner 620 and the first material 410 in the first set of pillar cavities 420. Additionally, or alternatively, the fifth processing step 800 may remove at least the portion of the second material 415 in the second set of pillar cavities 425 based on removing the first liner 620 and the first material 410 in the second set of pillar cavities 425.

In some examples, the portions may be etched using a wet etching process, such as a buffered oxide etch or a hydrofluoric (HF) etch (e.g., to merge the layers of the second material 415). In such examples, the layers of the second material 415 in the stack 455 of materials may be recessed relative to the layers of the first material 410 (e.g., etched up to the first liner 620 in each of the pillars 635). That is, as illustrated in the second top plan view 802, it may be understood that each layer of the first material 410 (e.g., layers of nitride materials) in the stack 455 of materials may not be etched in the fifth processing step 800 (e.g., the buffered oxide or HF etch may not substantially remove portions of the nitride material). For example, etching the second material 415 (e.g., the oxide material) may enable the first material 410 (e.g., the nitride material) to support the structure of the later features, such as the piers 440 or the comb edge structures 435.

In some examples, the first set of pillar cavities 420 may be etched separately (e.g., using a different etching process or the same etching process at a different time) from the second set of pillar cavities 425. For example, a mask (e.g., a second mask) may be applied to (e.g., deposited over) the second set of pillar cavities 425 and the first set of pillar cavities 420 may be etched to form the set of comb edge structure cavities based on applying the mask to the second set of pillar cavities 425 (e.g., or a mask may be applied to the first set of pillar cavities 420 and the second set of pillar cavities 425 may be etched to form the pier cavities 820 based on applying the mask). In some examples, a tolerance (e.g., the width of the etch) for etching the portion of the second set of pillar cavities 425 may be different than a tolerance for etching the portion for the first set of pillar cavities 420. In some other examples, the first material 410 and the first liner 620 in the first set of pillar cavities 420 and the first material 410 and the first liner 620 in the second set of pillar cavities 425 may be removed simultaneously.

A portion of the second set of pillar cavities 425 may be etched to form the pier cavities 820 based on etching a portion of the stack 455 of materials in each pillar cavity such that two pillar cavities merge to form a respective pier cavity 820 (e.g., at each layer of the second material 415). For example, a portion of the stack 455 may be etched from the first pillar cavity 425-a to form a wider cavity 820-a and a portion of the stack 455 may be etched from the second pillar cavity 425-b (e.g., an adjacent pillar cavity) to form a wider cavity 820-b (e.g., a wider cavity at each layer of the second material 415 in the stack 455). In some examples, a size of the portion etched in the second set of pillar cavities 425 may be based on a threshold length (e.g., a threshold length to merge respective pillar cavities of the second set of pillar cavities 425 into a pier cavity 820). Based on etching portions of the first pillar cavity 425-a and the second pillar cavity 425-b (e.g., at each of the second material 415 layers), the pillar cavities may merge into a single pier cavity 820. That is, adjacent pillar cavities of the second set of pillar cavities 425 may be merged based on removing the portion of the second material 415 in the second set of pillar cavities 425, and the one or more piers 440 may be formed based on merging the adjacent pillar cavities.

Additionally, or alternatively, the fifth processing step 800 may include an etching process that removes a portion of the first material 410 from each layer of the stack 455 of materials at each pillar cavity of the second set of pillar cavities 425 such that the sidewalls 470 of each pier cavity 820 are even (e.g., to remove the recesses of the nitride material and to level-set the sidewalls of the piers 440). That is, the fifth processing step 800 may include removing at least a portion of the first material 410 in the second set of pillar cavities 425, and merging the adjacent pillar cavities may be based on removing the portion of the first material.

In some examples, the first liner 620, the first material 410, or both, in each of the pillars 635 may be resistant to the buffered oxide or HF etch. That is, the buffered oxide etch (e.g., and/or HF etch) may not, at least substantially, remove portions of the first liner 620 or the first material 410 in the pillars 635 based on the first liner 620, as seen in the first cross-sectional view 805. For example, the first liner 620 may become an etch backstop (e.g., that prevents or otherwise resists etching by the buffered oxide or HF etch) during the merging of the adjacent pillar cavities to form the one or more piers 440. Based on the first liner 620 resisting the buffered oxide or HF etch, a respective pier 440 may connect physically to (e.g., contact or couple with) a respective pillar edge laterally. That is, a respective pier of the one or more piers 440 may couple with at least one pillar of the one or more pillars 635 at each layer of the second material 415 in the stack 455.

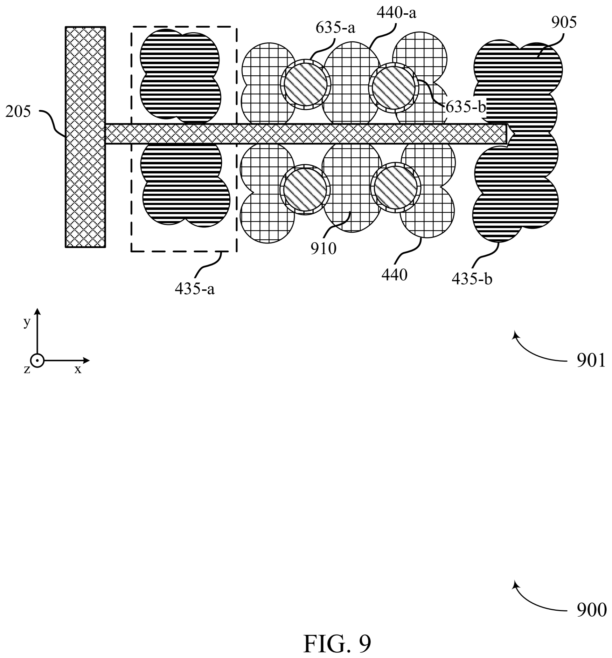

**FIG.** 9 shows an example of a sixth processing step 900 that supports a single etch and pier merge method for cell and comb features in accordance with examples as disclosed herein. The sixth processing step 900 illustrates a top plan view 901 (e.g., at a respective layer of the second material 415 in the stack 455) of comb edge structures 435, a word line 205, a set of piers 440, and a set of pillars 635.

The sixth processing step 900 may include depositing a third material 905 in the comb edge structure cavities 815 to form the one or more comb edge structures 435. In some examples, the third material 905 may include a dielectric material (e.g., a thermal-resistant oxide or nitride material) In some other examples, the third material 905 may be a sacrificial material that may be removed in later processing steps to form the memory array 200. In some examples, the comb edge structures 435 may define a boundary of a word line 205 (e.g., a comb structure).

The sixth processing step 900 may include forming the set of piers 440. For example, a fourth material 910 may be deposited in the set of pillar cavities 820 to form the one or more piers 440. In some examples, the fourth material 910 may be a nitride material. In some examples, the set of piers 440 may form one or more access lines 210 (e.g., as described with reference to FIGs. 2 and 3). A first pillar 635-a and a second pillar 635-b of the set of pillars 635 may be separated by a pier 440-a of the set of piers 440. Although not shown, it may be understood that the comb edge structures 435 may be extended (e.g., along the x direction) to electrically isolate the word line 205 from other word lines 205 (e.g., an adjacent even or odd word line 205). In some examples, the set of piers 440 and the set of pillars 635 may be positioned between the first comb edge structure 435-a and the second comb edge structure 435-b.

**FIG. 10** shows examples of cross-sectional views 1000 that support a single etch and pier merge method for cell and comb features in accordance with examples as disclosed herein. The cross-sectional views 1000 may include a first cross-sectional view 1005 of a pillar 635 and a second cross-sectional view 1010 of a comb edge structure cavity 815 and a pier cavity 820 on the substrate 405. For example, the first cross-sectional view 1005 and the second sectional view 1010 may illustrate cross-sectional views of the top plan view 801 illustrated in the fifth processing step 800 (e.g., the first cross-sectional view 1005 may correspond to the first cross-sectional view 805 and the second cross-sectional view 1010 may correspond to the second cross-sectional view 810).

The first cross-sectional view 1005 illustrates a landing pad 1015 (e.g., also referred to as a plug), a second liner 1030, and a pillar 635. In some examples, the second liner 1030 may include a SiCN material (e.g., the second liner 1030 may include the same material as the first liner 620). In some cases, the second liner 1030 may be deposited on the substrate 405 before the stack 455 of materials (e.g., before the first processing step 400). Additionally, or alternatively, the landing pad 1015 (e.g., and the landing pads 1020 and 1025) may be formed after the second liner 1030 is deposited and before the multiple pillar cavities are formed (e.g., before the first processing step 400). Each pillar 635 may include a respective landing pad 1015. In some examples, the landing pad 1015 may include a polysilicon material.

The second cross-sectional view 1010 illustrates a landing pad 1020, a landing pad 1025, the second liner 1030, a comb edge structure cavity 815, and two pier cavities 820. For example, the comb edge structure cavity 815 may include the landing pad 1020 and the two pier cavities 820 may include respective landing pads 1025. In some examples, the landing pad 1020 and the landing pad 1025 may include an aluminum oxide (e.g., AlOx) material, a tungsten (W) material, or any combination thereof. Each of the landing pads 1015, 1020, and 1025 may include etch landing zones (e.g., concave indentations or dimples) at a top surface of each of the landing pads where an etching process may terminate (e.g., an etch process may form the cavities beginning at the top of the stack 455 and continuing to a respective landing pad). In some examples, the second liner 1030 and the landing pads 1015, 1020, and 1025 may protect structures underlying the substrate 405 from the etching process described with reference to the fourth processing step 700 in FIG. 7.

It may be understood that the second liner 1030 and the landing pads 1015, 1020, and 1025 may be in the cross-sectional views of the processing steps described with reference to FIGs. 4 though 9 (e.g., the second liner 1030 and the landing pads 1015, 1020, and 1025 may not be illustrated FIGs. 4 through 9 for discussion purposes). For example, the set of piers 440 may extend through the stack 455 of materials and may be positioned above the landing pad 1025 (e.g., that extends into the substrate 405) and the set of pillars 635 may extend through the stack 455 of materials and may be positioned above the landing pad 1015 (e.g., that extends into the substrate 405). In another example, the set of comb edge structures 435 may extend through the stack 455 of materials, and each comb edge structure 435 (e.g., the first comb edge structure 435-a and/or the second comb edge structure 435-b) may be positioned above the landing pad 1020.

The cross sectional views 1000 may illustrate oxide recesses 1035 in the sidewalls 470 throughout the stack 455 of materials in each cavity (e.g., in the set of comb edge structure cavities 815, in the set of pier cavities 820, and adjacent to the pillars 635). As described herein, the oxide recesses 1035 may be based on the fifth processing step 800 described with reference to FIG. 8. For example, the fifth processing step 800 may include removing a portion of the second material 415 at each layer of the second material in the stack 455 for each cavity in accordance with a buffered oxide etch process or an HF etch process (e.g., the first material 410 may not be etched based on the etching process). In some examples, the oxide recesses 1035 may be in the cross-sectional views of the processing steps described with reference to FIGs. 8 and 9 (e.g., the oxide recesses 1035 may not be illustrated in FIGs. 8 and 9 for discussion purposes). For example, a portion of the first material 410 may extend, at each layer of the first material 410 in the stack 455 of materials, at least partially into a respective pier 440, a respective pillar 635, and a respective comb edge structure 435.

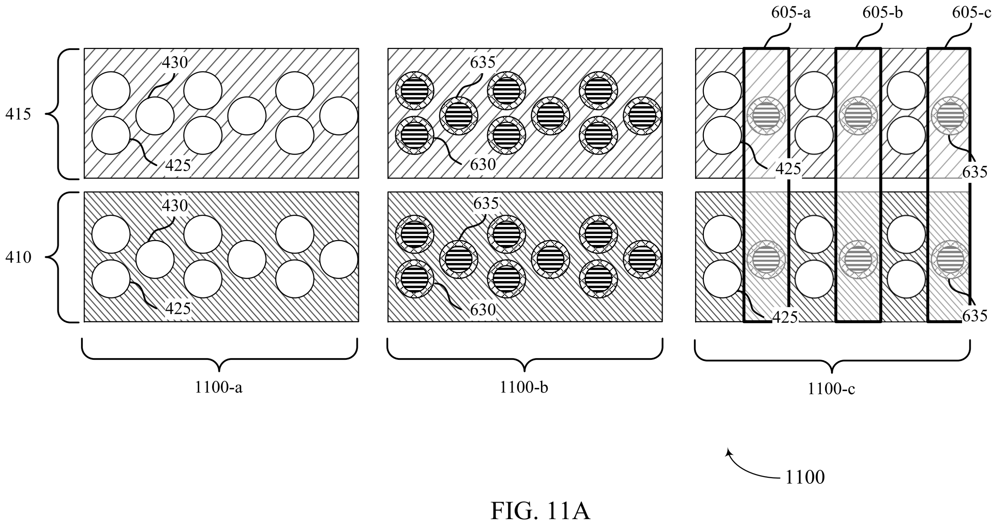

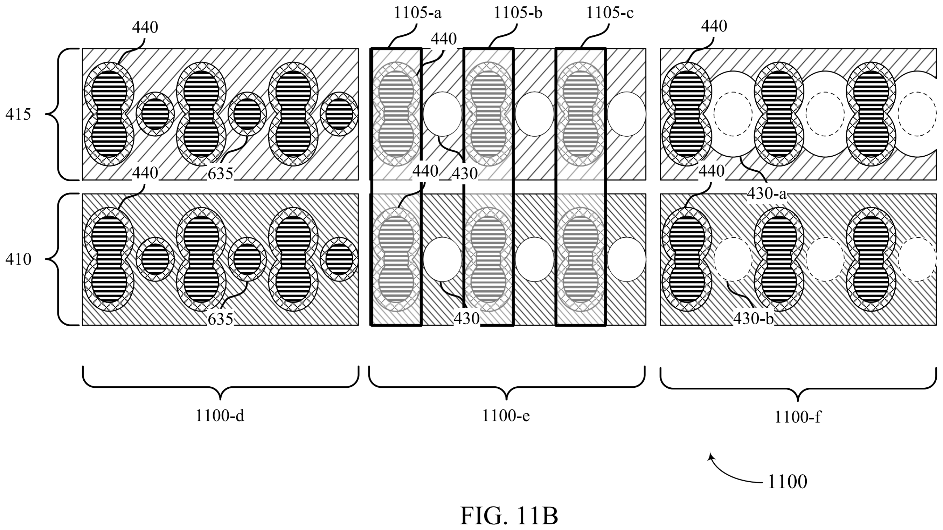

**FIGs. 11A** **and** **11B** show examples of elevation views 1100 at a first material layer and at a second material layer that supports a single etch and pier merge method for cell and comb features in accordance with examples as disclosed herein. The elevation views 1100 illustrates a top plan view at a layer the first material 410 and a top plan view at a layer of the second material 415 within the stack 455 corresponding to the first processing step 400 through the sixth processing step 900 described with reference to FIGs. 4 through 9.

**FIG. 11A** illustrates elevation views 1100-a through 1100-c corresponding to the first processing step 400 through the fourth processing step 700. For example, a first elevation view 1100-a illustrates a top plan view of the second set of pillar cavities 425 and the third set of pillar cavities 430 at a layer of the first material 410 and at a layer of the second material 415 (e.g., formed as described with reference to FIG. 4).

A second elevation view 1100-b illustrates a top plan view of the second set of pillars 630 and the third set of pillars 635 at a layer of the first material 410 and at a layer of the second material 415 (e.g., formed as described with reference to FIG. 6). For example, the second elevation view 1100-b may illustrate a pillar sacrificial fill (e.g., filling the pillar cavities with a SiCN liner and a nitride fill and/or polysilicon).

A third elevation view 1100-c illustrates a top plan view of the re-formed second set of pillar cavities 425, the first mask 605 (e.g., including the first portion 605-a, the second portion 605-b, and a third portion 605-c that are applied to the three illustrated columns of pillars 635), and pillars 635 at a layer of the first material 410 and at a layer of the second material 415 (e.g., formed as described with reference to FIGs. 6 and 7). For example, the third elevation view 1100-c may illustrate removing the sacrificial pillar material from the second set of pillars 630 by protecting the pillars 635 with the first mask 605 during an etching process (e.g., a wet etch process and/or vapor etch process).

FIG. 11B illustrates elevation views 1100-d through 1100-f corresponding to the fifth processing step 800 through an eleventh processing step. For example, a fourth elevation view 1100-d illustrates a top plan view of the set of piers 440 and pillars 635 at a layer of the first material 410 and at a layer of the second material 415 (e.g., formed as described with reference to FIGs. 8 and 9). For example, the fourth elevation view 1100-d may illustrate an enlargement of the pier cavities 820 (e.g., etching the second material 415 via a buffered oxide etch or HF etch and etching the first material 410 to level-set the sidewalls 470) and a filling of the pier cavities 820 with the first liner 620 and the fourth material 910 (e.g., the first material 410).

A fifth elevation view 1100-e illustrates a top plan view of the piers 440, a re-formed third set of pillar cavities 430, and a second mask 1105. The second mask 1105 may include at least a first portion 1105-a, a second portion 1105-b, and a third portion 1105-c applied to the piers 440. For example, the third set of pillar cavities 430 may be re-formed using an etching process that removes the first material 410 and the first liner 620 from the pillars 635. The second mask 1105 may protect the fourth material 910 and the first liner 620 in each of the piers 440 from being removed during the etching process in accordance with a tenth processing step. That is, tenth processing step may include applying a second masking material to the one or more piers 440 and removing, based on the second masking material, the first liner 620 and the first material 410 in the one or more pillars 635. In some examples, the one or more pillars 635 may be coupled with the one or more piers 440 based on removing the first liner 620 and the first material 410 in the one or more pillars 635.

A sixth elevation view 1100-f illustrates a top plan view of the set of piers 440 and the third set of pillar cavities 430. In some examples, an eleventh processing step may include etching portions of the pillar cavities 425 at each layer of the second material 415 (e.g., in the stack 455 of materials) using an etching process (e.g., a buffered oxide etch or an HF etch). The etching process may result in the third set of pillar cavities 430 including a first cavity size 430-a at layers of the first material 410 (e.g., not etched by the etching process in the eleventh processing step) and a second cavity size 430-b at layers of the second material 415, as illustrated in the elevation view 1100-f.

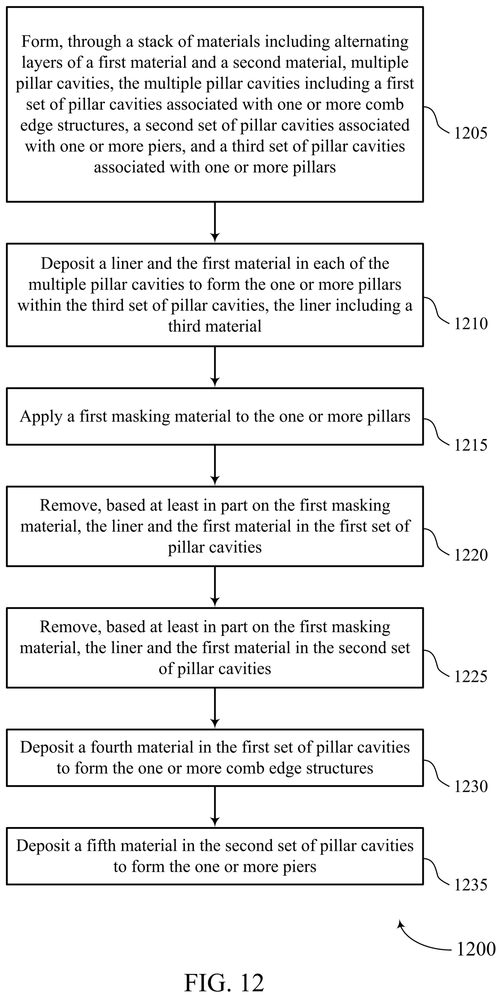

**FIG.** 12 shows a flowchart illustrating a method 1200 that supports a single etch and pier merge method for cell and comb features in accordance with examples as disclosed herein. The operations of method 1200 may be implemented by a manufacturing system or one or more controllers associated with a manufacturing system. For example, the operations of method 1200 may be performed by a manufacturing system as described with reference to FIGs. 1 through 12. In some examples, one or more controllers may execute a set of instructions to control one or more functional elements of the manufacturing system to perform the described functions. Additionally, or alternatively, one or more controllers may perform aspects of the described functions using special-purpose hardware.

At 1205, the method may include forming, through a stack of materials including alternating layers of a first material and a second material, multiple pillar cavities, the multiple pillar cavities including a first set of pillar cavities associated with one or more comb edge structures, a second set of pillar cavities associated with one or more piers, and a third set of pillar cavities associated with one or more pillars. In some examples, aspects of the operations of 1205 may be performed by a cavity forming component.

At 1210, the method may include depositing a liner and the first material in each of the multiple pillar cavities to form the one or more pillars within the third set of pillar cavities, the liner including a third material. In some examples, aspects of the operations of 1210 may be performed by a material depositing component.

At 1215, the method may include applying a first masking material to the one or more pillars. In some examples, aspects of the operations of 1215 may be performed by a masking component.

At 1220, the method may include removing, based at least in part on the first masking material, the liner and the first material in the first set of pillar cavities. In some examples, aspects of the operations of 1220 may be performed by a material removing component.

At 1225, the method may include removing, based at least in part on the first masking material, the liner and the first material in the second set of pillar cavities. In some examples, aspects of the operations of 1225 may be performed by a material removing component.

At 1230, the method may include depositing a fourth material in the first set of pillar cavities to form the one or more comb edge structures. In some examples, aspects of the operations of 1230 may be performed by a material depositing component.

At 1235, the method may include depositing a fifth material in the second set of pillar cavities to form the one or more piers. In some examples, aspects of the operations of 1235 may be performed by a material depositing component.

In some examples, an apparatus (e.g., a manufacturing system) as described herein may perform a method or methods, such as the method 1200. The apparatus may include features, circuitry, logic, means, or instructions (e.g., a non-transitory computer-readable medium storing instructions executable by a processor), or any combination thereof for performing the following aspects of the present disclosure:
Aspect 1: A method, apparatus, or non-transitory computer-readable medium including operations, features, circuitry, logic, means, or instructions, or any combination thereof for forming, through a stack of materials including alternating layers of a first material and a second material, a plurality of pillar cavities, the plurality of pillar cavities including a first set of pillar cavities associated with one or more comb edge structures, a second set of pillar cavities associated with one or more piers, and a third set of pillar cavities associated with one or more pillars; depositing a liner and the first material in each of the plurality of pillar cavities to form the one or more pillars within the third set of pillar cavities, the liner including a third material; applying a first masking material to the one or more pillars; removing, based at least in part on the first masking material, the liner and the first material in the first set of pillar cavities; removing, based at least in part on the first masking material, the liner and the first material in the second set of pillar cavities; depositing a fourth material in the first set of pillar cavities to form the one or more comb edge structures; and depositing a fifth material in the second set of pillar cavities to form the one or more piers.
Aspect 2: The method, apparatus, or non-transitory computer-readable medium of aspect 1, further including operations, features, circuitry, logic, means, or instructions, or any combination thereof for applying a second masking material to the one or more piers and removing, based at least in part on the second masking material, the liner and the first material in the one or more pillars, where the one or more pillars are coupled with the one or more piers based at least in part on removing the liner and the first material in the one or more pillars.
Aspect 3: The method, apparatus, or non-transitory computer-readable medium of any of aspects 1 through 2, further including operations, features, circuitry, logic, means, or instructions, or any combination thereof for removing at least a portion of the second material in the first set of pillar cavities based at least in part on removing the liner and the first material in the first set of pillar cavities; removing at least a portion of the second material in the second set of pillar cavities based at least in part on removing the liner and the first material in the second set of pillar cavities; merging two or more adjacent pillar cavities of the first set of pillar cavities based at least in part on removing the portion of the second material in the first set of pillar cavities, where the one or more comb edge structures are formed based at least in part on merging the two or more adjacent pillar cavities; and merging adjacent pillar cavities of the second set of pillar cavities based at least in part on removing the portion of the second material in the second set of pillar cavities, where the one or more piers are formed based at least in part on merging the adjacent pillar cavities.
Aspect 4: The method, apparatus, or non-transitory computer-readable medium of aspect 3, further including operations, features, circuitry, logic, means, or instructions, or any combination thereof for removing at least a portion of the first material in the second set of pillar cavities, where merging the adjacent pillar cavities is based at least in part on removing the portion of the first material.
Aspect 5: The method, apparatus, or non-transitory computer-readable medium of any of aspects 3 through 4, where the portion of the second material is removed via a buffered oxide etch process.
Aspect 6: The method, apparatus, or non-transitory computer-readable medium of any of aspects 1 through 5, where removing the liner and the first material includes operations, features, circuitry, logic, means, or instructions, or any combination thereof for removing the first material in the first set of pillar cavities and in the second set of pillar cavities via a first etch process and removing the liner via a second etch process.
Aspect 7: The method, apparatus, or non-transitory computer-readable medium of aspect 6, where the first etch process is associated with a wet etch process or vapor etch process and the second etch process is associated with the vapor etch process.
Aspect 8: The method, apparatus, or non-transitory computer-readable medium of any of aspects 1 through 7, further including operations, features, circuitry, logic, means, or instructions, or any combination thereof for forming one or more comb structures based at least in part on forming the one or more comb edge structures, where the one or more comb structures correspond to one or more word lines.
Aspect 9: The method, apparatus, or non-transitory computer-readable medium of any of aspects 1 through 8, where the first material and the liner in the first set of pillar cavities and the first material and the liner in the second set of pillar cavities are removed simultaneously.
Aspect 10: The method, apparatus, or non-transitory computer-readable medium of any of aspects 1 through 9, where the first material includes a nitride material and the second material includes an oxide material.
Aspect 11: The method, apparatus, or non-transitory computer-readable medium of any of aspects 1 through 10, where the third material includes a silicon carbon nitride material and the fourth material includes a dielectric material.

An apparatus is described. The following provides an overview of aspects of the apparatus as described herein:
Aspect 12: An apparatus, including: a substrate; a stack of materials including alternating layers of a first material and a second material; a plurality of piers extending through the stack of materials, where each pier of the plurality of piers is positioned above a third material that extends into the substrate; a plurality of pillars extending through the stack of materials, where each pillar of the plurality of pillars is positioned above a fourth material that extends into the substrate; and a plurality of comb edge structures extending through the stack of materials, where each comb edge structure of the plurality of comb edge structures is positioned above the third material, and where a portion of the first material extends, at each layer of the first material in the stack of materials, at least partially into a respective pier, a respective pillar, and a respective comb edge structure.
Aspect 13: The apparatus of aspect 12, where the plurality of comb edge structures includes a first comb edge structure and a second comb edge structure, the plurality of pillars and the plurality of piers positioned between the first comb edge structure and the second comb edge structure.
Aspect 14: The apparatus of any of aspects 12 through 13, where the plurality of comb edge structures form a boundary of one or more comb structures, the one or more comb structures corresponding to one or more word lines.
Aspect 15: The apparatus of any of aspects 12 through 14, where a first pillar and a second pillar of the plurality of pillars are separated by a pier of the plurality of piers.
Aspect 16: The apparatus of any of aspects 12 through 15, where each of the plurality of pillars includes the first material and a liner.
Aspect 17: The apparatus of aspect 16, where the liner includes a silicon carbon nitride material.
Aspect 18: The apparatus of any of aspects 12 through 17, where the first material includes a nitride material and the second material includes an oxide material.
Aspect 19: The apparatus of any of aspects 12 through 18, where the third material includes an aluminum oxide material or a tungsten material and the fourth material includes a polysilicon material.

An apparatus is described. The following provides an overview of aspects of the apparatus as described herein:
Aspect 20: An apparatus, including: one or more pillars; one or more piers; and one or more comb edge structures, where the one or more piers, the one or more pillars, and the one or more comb edge structures are formed by: forming, through a stack of materials including alternating layers of a first material and a second material, a plurality of pillar cavities, the plurality of pillar cavities including a first set of pillar cavities associated with the one or more comb edge structures, a second set of pillar cavities associated with the one or more piers, and a third set of pillar cavities associated with the one or more pillars; depositing a liner and the first material in each of the plurality of pillar cavities to form the one or more pillars within the third set of pillar cavities, the liner including a third material; applying a first masking material to the one or more pillars; removing, based at least in part on the first masking material, the liner and the first material in the first set of pillar cavities and in the second set of pillar cavities; and depositing a fourth material in the first set of pillar cavities to form the one or more comb edge structures and a fifth material in the second set of pillar cavities to form the one or more piers.

Information and signals described herein may be represented using any of a variety of different technologies and techniques. For example, data, instructions, commands, information, signals, bits, or symbols of signaling that may be referenced throughout the above description may be represented by voltages, currents, electromagnetic waves, magnetic fields or particles, optical fields or particles, or any combination thereof. Some drawings may illustrate signals as a single signal; however, the signal may represent a bus of signals, where the bus may have a variety of bit widths.

The terms "electronic communication," "conductive contact," "connected," and "coupled" may refer to a relationship between components that supports the flow of signals between the components. Components are considered in electronic communication with (or in conductive contact with or connected with or coupled with) one another if there is any conductive path between the components that can, at any time, support the flow of signals between the components. At any given time, the conductive path between components that are in electronic communication with each other (or in conductive contact with or connected with or coupled with) may be an open circuit or a closed circuit based on the operation of the device that includes the connected components. The conductive path between connected components may be a direct conductive path between the components or the conductive path between connected components may be an indirect conductive path that may include intermediate components, such as switches, transistors, or other components. In some examples, the flow of signals between the connected components may be interrupted for a time, for example, using one or more intermediate components such as switches or transistors.

The term "coupling" (e.g., "electrically coupling") may refer to condition of moving from an open-circuit relationship between components in which signals are not presently capable of being communicated between the components over a conductive path to a closed-circuit relationship between components in which signals are capable of being communicated between components over the conductive path. When a component, such as a controller, couples other components together, the component initiates a change that allows signals to flow between the other components over a conductive path that previously did not permit signals to flow.

The term "isolated" refers to a relationship between components in which signals are not presently capable of flowing between the components. Components are isolated from each other if there is an open circuit between them. For example, two components separated by a switch that is positioned between the components are isolated from each other when the switch is open. When a controller isolates two components, the controller affects a change that prevents signals from flowing between the components using a conductive path that previously permitted signals to flow.

The term "layer" or "level" used herein refers to a stratum or sheet of a geometrical structure (e.g., relative to a substrate). Each layer or level may have three dimensions (e.g., height, width, and depth) and may cover at least a portion of a surface. For example, a layer or level may be a three-dimensional structure where two dimensions are greater than a third, e.g., a thin-film. Layers or levels may include different elements, components, or materials. In some examples, one layer or level may be composed of two or more sublayers or sublevels.

The devices discussed herein, including a memory array, may be formed on a semiconductor substrate, such as silicon, germanium, silicon-germanium alloy, gallium arsenide, gallium nitride, etc. In some examples, the substrate is a semiconductor wafer. In other examples, the substrate may be a silicon-on-insulator (SOI) substrate, such as silicon-on-glass (SOG) or silicon-on-sapphire (SOP), or epitaxial layers of semiconductor materials on another substrate. The conductivity of the substrate, or sub-regions of the substrate, may be controlled through doping using various chemical species including, but not limited to, phosphorus, boron, or arsenic. Doping may be performed during the initial formation or growth of the substrate, by ion-implantation, or by any other doping means.

A switching component or a transistor discussed herein may represent a field-effect transistor (FET) and comprise a three terminal device including a source, drain, and gate. The terminals may be connected to other electronic elements through conductive materials, e.g., metals. The source and drain may be conductive and may comprise a heavily-doped, e.g., degenerate, semiconductor region. The source and drain may be separated by a lightly-doped semiconductor region or channel. If the channel is n-type (i.e., majority carriers are electrons), then the FET may be referred to as a n-type FET. If the channel is p-type (i.e., majority carriers are holes), then the FET may be referred to as a p-type FET. The channel may be capped by an insulating gate oxide. The channel conductivity may be controlled by applying a voltage to the gate. For example, applying a positive voltage or negative voltage to an n-type FET or a p-type FET, respectively, may result in the channel becoming conductive. A transistor may be "on" or "activated" when a voltage greater than or equal to the transistor's threshold voltage is applied to the transistor gate. The transistor may be "off" or "deactivated" when a voltage less than the transistor's threshold voltage is applied to the transistor gate.

The description set forth herein, in connection with the appended drawings, describes example configurations and does not represent all the examples that may be implemented or that are within the scope of the claims. The term "exemplary" used herein means "serving as an example, instance, or illustration," and not "preferred" or "advantageous over other examples." The detailed description includes specific details to provide an understanding of the described techniques. These techniques, however, may be practiced without these specific details. In some instances, well-known structures and devices are shown in block diagram form to avoid obscuring the concepts of the described examples.

In the appended figures, similar components or features may have the same reference label. Further, various components of the same type may be distinguished by following the reference label by a dash and a second label that distinguishes among the similar components. If just the first reference label is used in the specification, the description is applicable to any one of the similar components having the same first reference label irrespective of the second reference label.

The functions described herein may be implemented in hardware, software executed by a processing system (e.g., one or more processors, one or more controllers, control circuitry processing circuitry, logic circuitry), firmware, or any combination thereof. If implemented in software executed by a processing system, the functions may be stored on or transmitted over as one or more instructions (e.g., code) on a computer-readable medium. Due to the nature of software, functions described herein can be implemented using software executed by a processing system, hardware, firmware, hardwiring, or combinations of any of these. Features implementing functions may be physically located at various positions, including being distributed such that portions of functions are implemented at different physical locations.

Illustrative blocks and modules described herein may be implemented or performed with one or more processors, such as a DSP, an ASIC, an FPGA, discrete gate logic, discrete transistor logic, discrete hardware components, other programmable logic device, or any combination thereof designed to perform the functions described herein. A processor may be an example of a microprocessor, a controller, a microcontroller, a state machine, or other types of processors. A processor may also be implemented as at least one of one or more computing devices (e.g., a combination of a DSP and a microprocessor, multiple microprocessors, one or more microprocessors in conjunction with a DSP core, or any other such configuration).

As used herein, including in the claims, "or" as used in a list of items (for example, a list of items prefaced by a phrase such as "at least one of' or "one or more of') indicates an inclusive list such that, for example, a list of at least one of A, B, or C means A or B or C or AB or AC or BC or ABC (i.e., A and B and C). Also, as used herein, the phrase "based on" shall not be construed as a reference to a closed set of conditions. For example, an exemplary step that is described as "based on condition A" may be based on both a condition A and a condition B without departing from the scope of the present disclosure. In other words, as used herein, the phrase "based on" shall be construed in the same manner as the phrase "based at least in part on."

As used herein, including in the claims, the article "a" before a noun is openended and understood to refer to "at least one" of those nouns or "one or more" of those nouns. Thus, the terms "a," "at least one," "one or more," "at least one of one or more" may be interchangeable. For example, if a claim recites "a component" that performs one or more functions, each of the individual functions may be performed by a single component or by any combination of multiple components. Thus, the term "a component" having characteristics or performing functions may refer to "at least one of one or more components" having a particular characteristic or performing a particular function. Subsequent reference to a component introduced with the article "a" using the terms "the" or "said" may refer to any or all of the one or more components. For example, a component introduced with the article "a" may be understood to mean "one or more components," and referring to "the component" subsequently in the claims may be understood to be equivalent to referring to "at least one of the one or more components." Similarly, subsequent reference to a component introduced as "one or more components" using the terms "the" or "said" may refer to any or all of the one or more components. For example, referring to "the one or more components" subsequently in the claims may be understood to be equivalent to referring to "at least one of the one or more components."

Computer-readable media includes both non-transitory computer storage media and communication media including any medium that facilitates transfer of a computer program from one place to another. A non-transitory storage medium may be any available medium, or combination of multiple media, which can be accessed by a computer. By way of example, and not limitation, non-transitory computer-readable media can comprise RAM, ROM, electrically erasable programmable read-only memory (EEPROM), optical disk storage, magnetic disk storage or other magnetic storage devices, or any other non-transitory medium or combination of media that can be used to carry or store desired program code means in the form of instructions or data structures and that can be accessed by a computer, or one or more processors.

The description herein is provided to enable a person skilled in the art to make or use the disclosure. Various modifications to the disclosure will be apparent to those skilled in the art, and the generic principles defined herein may be applied to other variations without departing from the scope of the invention as defined by the appended claims. herein.

Further embodiments are set out in the following clauses in which:
1. An apparatus, comprising:
   a substrate;
   a stack of materials comprising alternating layers of a first material and a second material;
   a plurality of piers extending through the stack of materials, wherein each pier of the plurality of piers is positioned above a third material that extends into the substrate;
   a plurality of pillars extending through the stack of materials, wherein each pillar of the plurality of pillars is positioned above a fourth material that extends into the substrate; and
   a plurality of comb edge structures extending through the stack of materials, wherein each comb edge structure of the plurality of comb edge structures is positioned above the third material, and wherein a portion of the first material extends, at each layer of the first material in the stack of materials, at least partially into a respective pier, a respective pillar, and a respective comb edge structure.
2. The apparatus of clause 1, wherein the plurality of comb edge structures comprises a first comb edge structure and a second comb edge structure, the plurality of pillars and the plurality of piers positioned between the first comb edge structure and the second comb edge structure.
3. The apparatus of clause 1, wherein the plurality of comb edge structures form a boundary of one or more comb structures, the one or more comb structures corresponding to one or more word lines.
4. The apparatus of clause 1, wherein a first pillar and a second pillar of the plurality of pillars are separated by a pier of the plurality of piers.
5. The apparatus of clause 1, wherein each of the plurality of pillars comprises the first material and a liner.
6. The apparatus of clause 5, wherein the liner comprises a silicon carbon nitride material.
7. The apparatus of clause 1, wherein the first material comprises a nitride material and the second material comprises an oxide material.
8. The apparatus of clause 1, wherein the third material comprises an aluminum oxide material or a tungsten material and the fourth material comprises a polysilicon material.
9. A method, comprising:
   forming, through a stack of materials comprising alternating layers of a first material and a second material, a plurality of pillar cavities, the plurality of pillar cavities comprising a first set of pillar cavities associated with one or more comb edge structures, a second set of pillar cavities associated with one or more piers, and a third set of pillar cavities associated with one or more pillars;
   depositing a liner and the first material in each of the plurality of pillar cavities to form the one or more pillars within the third set of pillar cavities, the liner comprising a third material;
   applying a first masking material to the one or more pillars;
   removing, based at least in part on the first masking material, the liner and the first material in the first set of pillar cavities;
   removing, based at least in part on the first masking material, the liner and the first material in the second set of pillar cavities;
   depositing a fourth material in the first set of pillar cavities to form the one or more comb edge structures; and
   depositing a fifth material in the second set of pillar cavities to form the one or more piers.
10. The method of clause 9, further comprising:
   applying a second masking material to the one or more piers; and
   removing, based at least in part on the second masking material, the liner and the first material in the one or more pillars, wherein the one or more pillars are coupled with the one or more piers based at least in part on removing the liner and the first material in the one or more pillars.
11. The method of clause 9, further comprising:
   removing at least a portion of the second material in the first set of pillar cavities based at least in part on removing the liner and the first material in the first set of pillar cavities;
   removing at least a portion of the second material in the second set of pillar cavities based at least in part on removing the liner and the first material in the second set of pillar cavities;
   merging two or more adjacent pillar cavities of the first set of pillar cavities based at least in part on removing the portion of the second material in the first set of pillar cavities, wherein the one or more comb edge structures are formed based at least in part on merging the two or more adjacent pillar cavities; and
   merging adjacent pillar cavities of the second set of pillar cavities based at least in part on removing the portion of the second material in the second set of pillar cavities, wherein the one or more piers are formed based at least in part on merging the adjacent pillar cavities.
12. The method of clause 11, further comprising:
   removing at least a portion of the first material in the second set of pillar cavities,
   wherein merging the adjacent pillar cavities is based at least in part on removing the portion of the first material.
13. The method of clause 11, wherein the portion of the second material is removed via a buffered oxide etch process.
14. The method of clause 9, wherein removing the liner and the first material comprises:
   removing the first material in the first set of pillar cavities and in the second set of pillar cavities via a first etch process; and
   removing the liner via a second etch process.
15. The method of clause 14, wherein:
   the first etch process is associated with a wet etch process or vapor etch process, and
   the second etch process is associated with the vapor etch process.
16. The method of clause 9, further comprising:
   forming one or more comb structures based at least in part on forming the one or more comb edge structures, wherein the one or more comb structures correspond to one or more word lines.
17. The method of clause 9, wherein the first material and the liner in the first set of pillar cavities and the first material and the liner in the second set of pillar cavities are removed simultaneously.
18. The method of clause 9, wherein the first material comprises a nitride material and the second material comprises an oxide material.
19. The method of clause 9, wherein the third material comprises a silicon carbon nitride material and the fourth material comprises a dielectric material.
20. An apparatus, comprising:
   one or more pillars;
   one or more piers; and
   one or more comb edge structures, wherein the one or more piers, the one or more pillars, and the one or more comb edge structures are formed by:
      forming, through a stack of materials comprising alternating layers of a first material and a second material, a plurality of pillar cavities, the plurality of pillar cavities comprising a first set of pillar cavities associated with the one or more comb edge structures, a second set of pillar cavities associated with the one or more piers, and a third set of pillar cavities associated with the one or more pillars;
      depositing a liner and the first material in each of the plurality of pillar cavities to form the one or more pillars within the third set of pillar cavities, the liner comprising a third material;
      applying a first masking material to the one or more pillars; removing, based at least in part on the first masking material, the liner and the first material in the first set of pillar cavities and in the second set of pillar cavities; and
      depositing a fourth material in the first set of pillar cavities to form the one or more comb edge structures and a fifth material in the second set of pillar cavities to form the one or more piers.

## Claims

1. An apparatus, comprising:
a substrate;
a stack of materials comprising alternating layers of a first material and a second material;
a plurality of piers extending through the stack of materials, wherein each pier of the plurality of piers is positioned above a third material that extends into the substrate;
a plurality of pillars extending through the stack of materials, wherein each pillar of the plurality of pillars is positioned above a fourth material that extends into the substrate; and
a plurality of comb edge structures extending through the stack of materials, wherein each comb edge structure of the plurality of comb edge structures is positioned above the third material, and wherein a portion of the first material extends, at each layer of the first material in the stack of materials, at least partially into a respective pier, a respective pillar, and a respective comb edge structure.

2. The apparatus of claim 1, wherein the plurality of comb edge structures comprises a first comb edge structure and a second comb edge structure, the plurality of pillars and the plurality of piers positioned between the first comb edge structure and the second comb edge structure.

3. The apparatus of either of claims 1 or 2, wherein the plurality of comb edge structures form a boundary of one or more comb structures, the one or more comb structures corresponding to one or more word lines.

4. The apparatus of any preceding claim, wherein a first pillar and a second pillar of the plurality of pillars are separated by a pier of the plurality of piers.

5. The apparatus of any preceding claim, wherein each of the plurality of pillars comprises the first material and a liner.

6. The apparatus of claim 5, wherein the liner comprises a silicon carbon nitride material.

7. The apparatus of any preceding claim, wherein the first material comprises a nitride material and the second material comprises an oxide material.

8. The apparatus of any preceding claim, wherein the third material comprises an aluminum oxide material or a tungsten material and the fourth material comprises a polysilicon material.
